# EUROPÄISCHE PATENTSCHRIFT

(11) **EP 4 183 664 B1**
(45) Veröffentlichungstag und Bekanntmachung des Hinweises auf die Patenterteilung: **10.09.2025**
(21) Anmeldenummer: 22196367.1
(22) Anmeldetag: 19.09.2022
(51) Int. Cl.: B62D 5/04

(54) **KASKADIERTES ABSCHALTSYSTEM BEI FLÜSSIGKEITSEINTRITT INS LENKSYSTEM EINES FAHRZEUGS**
CASCADED SHUT-OFF SYSTEM FOR FLUID ENTRY INTO THE STEERING SYSTEM OF A VEHICLE
SYSTÈME D'ARRÊT EN CASCADE DE L'ENTRÉE DE LIQUIDE DANS UN SYSTÈME DE DIRECTION D'UN VÉHICULE

(30) Priorität: 19.11.2021 DE 102021213055
(43) Veröffentlichungstag der Anmeldung: 24.05.2023
(73) Patentinhaber: VOLKSWAGEN AG, 38440 Wolfsburg (DE)
(72) Erfinder: Schumann, Heiko, 38116 Braunschweig (DE); Bunzendahl, Jörg, 30171 Hannover (DE); Kempf, Tim, 38110 Braunschweig (DE)

(56) Entgegenhaltungen:
- EP-B1- 3 672 859
- DE-A1- 102015 115 118

## Beschreibung

### Technisches Gebiet

Die Erfindung betrifft ein Fahrzeug mit einem Steuergerät, das zur elektrischen Ansteuerung einer integrierten Fahrzeugeinrichtung, insbesondere einer Lenkung, einer Bremse oder eines elektrischen Antriebsstrangs, ausgebildet ist. Beim Fahrzeug kann es sich um ein Kraftfahrzeug oder ein andersartiges Land-, Luft- oder Wasserfahrzeug handeln.

### Technischer Hintergrund

Wassereintritt in Lenksysteme ist nicht auszuschließen und kann beispielsweise durch defekte Manschetten bedingt sein. In der Regel erfolgt nach einer gewissen Zeit eine harte Abschaltung über eine ungerichtete Fehlererkennung in der zugehörigen Steuerelektronik. Insbesondere bei hohen Fahrzeuggewichten und daraus resultierenden hohen Lenkkräften kann das allerdings nicht mehr akzeptabel sein.

Im Stand der Technik sind zum Erkennen eines Feuchtigkeitseintritts in ein System verschiedenartige Flüssigkeits- und Wassersensoren bekannt. So offenbart beispielsweise die deutsche Patentschrift DE 1018649 B ein Verfahren zur elektrisch indizierten Feuchtigkeitsmessung und eine Elektrode zur Ausübung des Verfahrens. Ferner beschreibt beispielsweise DE 10 2016 007 297 A1 eine Meßwertänderungserfassungsvorrichtung, die derart ausgebildet ist, dass bei Anwesenheit von Wasser an der Vorrichtung eine Veränderung eines von der Vorrichtung erfassten elektrischen Widerstandes gemessen wird oder messbar ist. Des Weiteren ist für elektromechanische Lenksysteme mit einem Achs-Parallel-Antrieb das Überspringen eines Antriebsriemens nach hinreichend langem Kontakt zu Wasser und entsprechenden Erkennungsalgorithmen als Abschaltmaßnahme bekannt.

Die Druckschrift EP 3 672 859 offenbart einen Antriebsanteil, insbesondere ein Lenksystem für ein Kraftfahrzeug, umfassend einen Elektromotor und mindestens ein Steuergerät, wobei der Elektromotor mindestens eine Wicklung aufweist, wobei die Wicklung Anschlusspunkte für eine Leistungselektronik des mindestens einen Steuergeräts aufweist, wobei das Antriebsbauteil mindestens eine Sensorik zur Erfassung von Flüssigkeit aufweist, wobei die Sensorik eine Auswerte- und Steuereinheit aufweist, die mit den Anschlusspunkten der mindestens einen Wicklung verbunden ist, wobei die Auswerte- und Steuereinheit derart ausgebildet ist, ein Testsignal zu erzeugen und eine Impedanzänderung zu erfassen.

Die Druckschrift DE 10 2015 115 118 A1 offenbart eine Vorrichtung zum Betreiben eines Lenksystems, das zumindest einen elektrisch betreibbaren Aktuator aufweist, mit mindestens einem Trägersubstrat, auf welchem ein erstes Elektroniksystem und ein dazu zumindest teilweise redundantes zweites Elektroniksystem zum Betreiben des Aktuators angeordnet sind, wobei das mindestens eine Trägersubstrat zumindest bereichsweise mit einer Schutzschicht flüssigkeitsdicht versiegelt ist, dadurch gekennzeichnet, dass das erste Elektroniksystem zumindest im Wesentlichen durch die Schutzschicht versiegelt ist, und dass das zweite Elektroniksystem zumindest teilweise schutzschichtfrei ist.

Bekannte Abschaltsysteme, die auf einer Wassereintrittserkennung durch Wassersensoren beruhen, zeichnen sich durch einen hohen Anteil von Fehlerkennung und erhebliche Mehrkosten aus. Auch bei der Lösung über den überspringenden Antriebsriemen ist eine vergleichsweise schlechte Zuverlässigkeit zu verzeichnen.

Es ist Aufgabe der vorliegenden Erfindung, einen alternativen oder verbesserten Abschaltmechanismus für Lenksysteme und andere gegenüber einem Wassereintritt empfindliche Einrichtungen in einem Fahrzeug bereitzustellen. Die Erfindung richtet sich dabei insbesondere auf die Vermeidung einer harten Abschaltung bei Wassereintritt und/oder auf eine verbesserte Erkennung eines Wassereintritts.

### Offenbarung der Erfindung

Diese Aufgabe wird durch ein Fahrzeug mit einem Steuergerät gemäß Anspruch 1 gelöst.

Weitere Ausgestaltungen sind in den abhängigen Ansprüchen angegeben.

Gemäß einem ersten Aspekt ist ein Fahrzeug, insbesondere ein Kraftfahrzeug, vorgesehen. Umfassend eine integrierte Fahrzeugeinrichtung; und ein Steuergerät, das zur elektrischen Ansteuerung der integrierten Fahrzeugeinrichtung, insbesondere einer Lenkung, einer Bremse oder eines elektrischen Antriebsstrangs, ausgebildet und eingerichtet ist und hierzu beispielsweise eine oder mehrere Leiterplatten mit darauf ausgebildeter Ansteuerungselektronik umfassen kann, die hierin nachfolgend generell als "Hardware" bezeichnet wird. Beim Fahrzeug kann es sich insbesondere um ein Kraftfahrzeug, aber auch um ein beliebiges anderes Land-, Luft- oder Wasserfahrzeug handeln. Die genannte Fahrzeugeinrichtung kann insbesondere ein Lenksystem, ein Bremssystem oder beispielsweise auch ein elektrischer Antriebsstrang sein.

Das Steuergerät ist als ein sogenanntes zweikanaliges Steuergerät ausgebildet, indem es einen ersten Ansteuerungskanal (nachfolgend kurz "erster Kanal" genannt) und einen redundanten zweiten Ansteuerungskanal (nachfolgend kurz "zweiter Kanal" genannt), der zu einer unabhängigen Ansteuerung der Fahrzeugeinrichtung bei Ausfall des ersten Kanals ausgebildet ist, umfasst. Dabei ist zumindest ein Teil von Hardwarekomponenten des ersten Kanals derart flüssigkeitsempfindlich ausgebildet und angeordnet, dass ein Flüssigkeitseintritt ins Steuergerät zu einer direkten und/oder automatisch herbeigeführten Abschaltung des ersten Kanals führt. Dies kann beispielsweise dadurch realisiert sein, dass bestimmte elektrische Leiter(bahnen) des ersten Kanals durch eintretende Flüssigkeit (beispielsweise Wasser) miteinander verbunden werden und dadurch eine direkte Abschaltung der elektrischen Schaltung des ersten Kanals bewirken. Alternativ oder zusätzlich kann der erste Kanal durch einen geeigneten Algorithmus, beispielsweise unter Verwendung von entsprechend programmierter Software, basierend auf einem einschlägigen Signal eines oder mehrerer Wassersensoren, die im ersten Kanal verbaut sind, automatisch abgeschaltet werden.

Im Unterschied zum ersten Kanal sind Hardwarekomponenten des zweiten Kanals, die durch einen Flüssigkeitseintritt sonst beschädigt oder beeinflusst werden könnten, derart flüssigkeitsgeschützt ausgeführt und/oder angeordnet, dass der zweite Kanal bei Eindringen von Flüssigkeit (beispielsweise Wasser) ins Steuergerät zumindest für eine vorbestimmte Zeitspanne voll funktionsfähig bleibt, nachdem der erste Kanal flüssigkeitsbedingt ausgefallen ist. Diese Zeitspanne von beispielsweise einigen Minuten oder mehr ist dabei so gewählt, dass sie zum Überführen des Fahrzeugs in einen vorbestimmten sicheren Zustand - wie beispielsweise fürs rechte Heranfahren des Fahrzeugs bis zu seinem Stillstand auf einem Standstreifen oder am rechten Straßenrand - ausreicht.

Basis der Erfindung sind somit sogenannte zweikanalige Steuergeräte, wie sie zum Erzielen der geforderten Verfügbarkeiten etwa bei Lenkungen oder anderen sicherheitsrelevanten Systemen im Fahrzeug zum Einsatz kommen. Eine Idee der Erfindung besteht dabei darin, dass ein erster Kanal bei Eintritt von Wasser oder einer anderen schädlichen Flüssigkeit ins Steuergerät schnell ausfallen soll, der redundante zweite Kanal hingegen noch etwas länger betriebsbereit bleibt. Einige Möglichkeiten, dies konstruktiv zu erreichen, sind weiter unten angegeben. Mit dem noch funktionierenden zweiten Kanal lässt sich das Fahrzeug in einen geeigneten sicheren Zustand überführen. Das Ausfallen/Abschalten des ersten Kanals kann dabei beispielsweise über eine geeignete Software sicher erkannt und eine entsprechende Fehlerreaktion ausgelöst werden.

Mit anderen Worten ist das hierin vorgestellte Steuergerät mit einem kaskadierten Abschaltsystem für den Fall eines Flüssigkeitseintritts ausgestattet. Dies ist durch einen gezielten Schutz nur eines der beiden Kanäle, beispielsweise durch eine geeignete/gezielte Anordnung der zugehörigen Hardwareelemente auf einer oder mehrerer Leiterplatten im Steuergerät, gewährleistet.

Die Erfindung kann insbesondere bei allen Lenkungen mit zweikanaligem, tief liegendem Steuergerät zum Einsatz kommen. Generell ist sie auch bei allen anderen Steuergeräten dieser Art (d. h. nicht nur in Lenksystemen) mit hohen Sicherheitsanforderungen und gewisser Wahrscheinlichkeit von Feuchtigkeitseintritt anwendbar.

Das hierin beschriebene Steuergerät zeichnet sich durch eine besonders hohe und selbst im sicherheitsrelevanten Aufgabenbereich (wie bei einer elektrisch unterstützten Lenkung eines schweren Fahrzeugs oder beim autonomen Fahren) zuverlässige Verfügbarkeit im Fall eines Flüssigkeitseintritts aus und ist dabei kostengünstig und mit einem relativ geringen Qualifizierungsaufwand herstellbar. Grundsätzlich sind für die Realisierung der Erfindung auch keine zusätzlichen Bauteile erforderlich.

Insbesondere kann das Steuergerät dazu eingerichtet sein, bei einem hierin beschriebenen flüssigkeitsbedingten Ausfall oder Abschaltung des ersten Kanals die Fahrzeugeinrichtung über den zweiten Kanal zum selbsttätigen Überführen des Fahrzeugs in den vorbestimmten sicheren Zustand anzusteuern. Alternativ oder zusätzlich kann ein Warnsignal für Fahrzeuginsassen und/oder Außenstehende erzeugt werden, das auf den Flüssigkeitseintritt im Steuergerät hinweist und zu einem sofortigen sicheren Abstellen des Fahrzeugs auffordert. Ein geeignetes Warnsignal kann beispielsweise optisch, etwa in Form blinkender oder grell aufleuchtender Symbole in Signalfarben wie rot oder orange etc.; und/oder akustisch, etwa in Form einer Lautsprecherdurchsage, und/oder vieles mehr sein. Darüber hinaus kann durch das Steuergerät mindestens eine vorbestimmte Weiterfahrt-Sperrmaßnahme im Fahrzeug aktiviert werden, sobald das Fahrzeug in den vorbestimmten sicheren Zustand überführt worden ist, um eine Weiterfahrt des Fahrzeugs durch fahrzeuginterne autonome Systeme oder nicht informierte Fahrzeugführer zuverlässig zu verhindern, solange der Flüssigkeitseintritt nicht mit geeigneten Fachmaßnahmen vollständig behoben ist. Als Weiterfahrt-Sperrmaßnahmen können beispielsweise eine Bremse und/oder Lenkradsperre oder vieles mehr im Fahrzeug aktiviert werden.

Erfindungsgemäß ist Hardware des zweiten Kanals ausschließlich oder unter anderem dadurch im Gegensatz zur Hardware des ersten Kanals flüssigkeitsgeschützt ausgebildet, dass der zweite Kanal beim Einbau des Steuergeräts in einem Fahrzeug höher als der erste Kanal positioniert ist. Mit anderen Worten beruht diese Ausführungsform darauf, dass der erste Kanal des Steuergerätes geodätisch unten und der zweite Kanal oben angeordnet sind. Dahinter steht die allgemeine Erkenntnis, dass Wasser oder andere Flüssigkeiten in aller Regel unter der Wirkung der Schwerkraft nach unten fließen, wenn sie ins Steuergerät von außen eintreten. Damit wird erreicht, dass der erste Kanal bei Wassereintritt schnell ausfällt, der zweite jedoch länger betriebsbereit ist.

Alternativ oder zusätzlich dazu kann gemäß einer weiteren Ausführungsform Hardware des zweiten Kanals im Gegensatz zur Hardware des ersten Kanals dadurch flüssigkeitsgeschützt ausgebildet sein, dass allein Elektronikbausteine des zweiten Kanals mit geeigneten zusätzlichen Schutzmaßnahmen vor Feuchtigkeit geschützt (z. B. lackiert) sind. Hierzu können beispielsweise zumindest diejenigen Hardwarekomponenten des zweiten Kanals, die ohne solche Schutzmaßnahmen in ihrer Funktion durch Flüssigkeit beeinträchtigt werden würden, mit einer wasserdichten Abdeckung, etwa durch Lackierung oder auch eine Folie oder Schicht aus Gummi oder Kunststoff etc., überzogen sein/werden.

Insbesondere kann das Steuergerät in zwei separate, räumlich und elektrisch vollständig voneinander getrennte Teil-Steuergeräte unterteilt sein, wobei der erste Kanal in einem und der zweite Kanal in dem anderen Teil-Steuergerät untergebracht ist. Dadurch können die hierin beschriebenen Unterschiede in der Ausgestaltung beider Kanäle konstruktiv besonders einfach und wirksam umgesetzt werden.

Insbesondere kann Hardware des ersten Kanals gezielt für eine sichere Erkennung eines Flüssigkeitseintritts, der beispielsweise eine bloße Kondensation von Feuchtigkeit aus der Luft mengenmäßig um ein Vielfaches übersteigt, ausgebildet sein. Dadurch kann eine fehlerhafte Erkennung, die ohne tatsächliche Not zu einer direkten oder automatischen Abschaltung des ersten Kanals führen würde, ausgeschlossen werden. Dies kann beispielsweise konstruktiv dadurch erreicht werden, dass Leiter(bahnen), die bei Flüssigkeitseintritt zu dessen Erkennung kurzzuschließen sind, einen vorbestimmten Mindestabstand voneinander aufweisen. Alternativ oder zusätzlich können beispielsweise mehrere voneinander unabhängige elektrische und/oder sensortechnische Bausteine in die genannte Erkennung einfließen, um eine Fehlerkennung auszuschließen. Mit vergleichsweise geringen Kosten kann dadurch erreicht werden, dass eine Fehlerreaktion nur dann ausgelöst wird, wenn wirklich Wasser im System ist.

In diesem Zusammenhang kann der erste Kanal insbesondere einen oder mehrere Sensoren umfassen, die zum Erkennen eines Flüssigkeitseintritts im ersten Kanal und zum Ausgeben eines entsprechenden Signals an das Steuergerät zum automatischen Abschalten des ersten Kanals ausgebildet sind. Geeignete Flüssigkeits- oder Feuchtigkeitssensoren, die auf elektrischen oder anderen physikalischen Vorgängen beruhen können, sind im Stand der Technik an sich vielfach bekannt, wie eingangs erwähnt.

### Kurzbeschreibung der Zeichnungen

Oben beschriebene Ausführungsformen und Ausgestaltungsvarianten werden nachfolgend anhand der in beigefügten Zeichnungen dargestellten Beispiele näher erläutert. Die Zeichnungen sind grundsätzlich als schematisch zu verstehen, d. h. sie dienen in erster Linie einer Veranschaulichung des allgemeineren Wirkungsprinzips der Erfindung. Gleiche oder entsprechende Elemente tragen in den Zeichnungen gleiche Bezugszeichen. Es zeigen:
- Figur 1: ein Ausführungsbeispiel eines Steuergeräts der hierin dargelegten Art für eine elektromechanische Fahrzeuglenkung, das zur Erkennung von Feuchtigkeitseintritt und zur daraus resultierenden kaskadierten Abschaltung ausgebildet und eingerichtet ist;
- Figur 2: zum Vergleich eine Leiterplatte eines herkömmlichen zweikanaligen Steuergeräts mit einer geodätisch zufälligen Positionierung der Leiterplatte im Fahrzeug; und
- Figur 3: eine Leiterplatte des Steuergeräts der Fig. 1 mit darauf ausgebildeten Hardwarekomponenten eines ersten und eines redundanten zweiten Ansteuerungskanals, wobei der zweite Kanal im Gegensatz zum ersten Kanal flüssigkeitsgeschützt ausgebildet und angeordnet ist.

### Beschreibung von Ausführungsformen

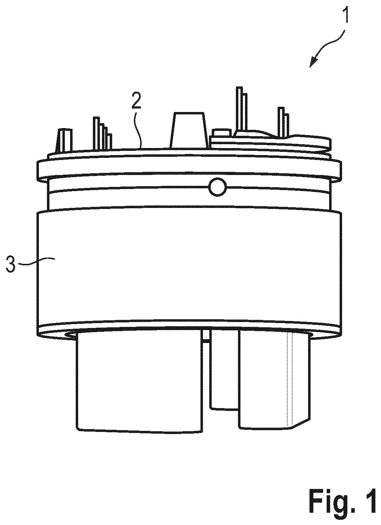

Fig. 1 zeigt schematisch ein Ausführungsbeispiel eines Steuergeräts 1 der hierin dargelegten Art für eine integrierte Fahrzeugeinrichtung, in einer perspektivischen Seitenansicht. Rein beispielhaft handelt es sich hierbei um ein Steuergerät eines elektromechanischen Lenksystems mit einem Achs-Parallel-Antrieb für ein Kraftfahrzeug (nicht dargestellt). Das Steuergerät 1 weist eine Leiterplatte 2 mit darauf ausgebildeter Ansteuerungselektronik ("Hardware") auf. Darunter können in einem Gehäuse 3 des Steuergeräts 1 seine weiteren elektrischen und mechanischen Bauteile, wie beispielsweise elektromechanische Aktuatoren, untergebracht sein.

Das Steuergerät 1 ist zur Erkennung von Feuchtigkeitseintritt und zu einer daraus resultierenden kaskadierten Abschaltung ausgebildet und eingerichtet. Als notwendige Voraussetzung hierfür weist es zwei unabhängige Ansteuerungskanäle - einen ersten und einen zweiten Kanal, - auf, deren Hardwarekomponenten auf der Leiterplatte 2 separat voneinander ausgebildet sind.

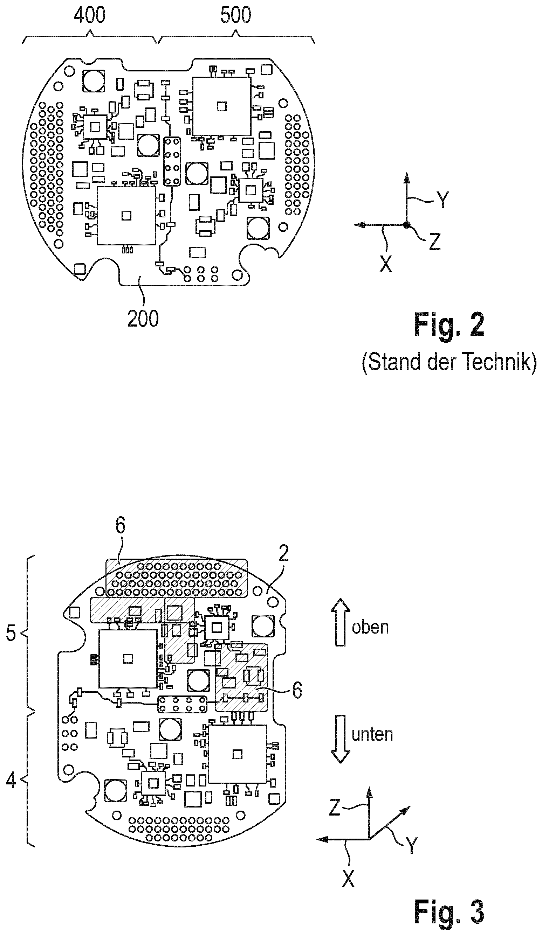

Fig. 2 zeigt zum Vergleich mit einer Ausführungsform der Erfindung (die in Fig. 3 gezeigt ist) eine Leiterplatte 200 eines herkömmlichen zweikanaligen Steuergeräts mit einer geodätisch zufälligen Positionierung der Leiterplatte 200, die bezüglich des üblichen fahrzeugeigenen Koordinatensystems mit zueinander senkrechten Längs-, Quer- und Höhenachsen X, Y und Z veranschaulicht ist. In der Draufsicht der Fig. 2 sind Hardwarekomponenten eines ersten Kanals 400 links und eines redundanten zweiten Kanals 500 rechts, in etwa auf der gleichen Höhe bezüglich der Fahrzeughöhenachse Z angeordnet.

Fig. 3 zeigt, wiederum in einer Draufsicht, die Leiterplatte 2 des Steuergeräts 1 der Fig. 1 mit darauf ausgebildeten Hardwarekomponenten eines ersten Kanals 4 und eines redundanten zweiten Kanals 5. Im Unterschied zu der herkömmlichen Ausgestaltung gemäß Fig. 2, ist in Fig. 3 der zweite Kanal 5 extra flüssigkeitsgeschützt ausgebildet und angeordnet, im Gegensatz zum ersten Kanal 4, dessen Ausgestaltung und Anordnung dafür ausgelegt sind, dass der erste Kanal 4 bei unerwünschtem Flüssigkeitseintritt ins Steuergerät 1 der Flüssigkeit als erster ausgesetzt wird und ausfällt, bevor der zweite Kanal 5 ebenfalls betroffen ist. Durch den flüssigkeitsbedingten Ausfall des ersten Kanals 4 wird der Flüssigkeitseintritt im Steuergerät 1 erkannt, woraufhin der weiterhin funktionsfähige zweite Kanal 5 dazu genutzt wird, das Fahrzeug auf kürzestem Wege in einen sicheren Zustand zu überführen, bevor auch der zweite Kanal 5 stillgelegt wird.

Hierzu ist die Leiterplatte 2 in Fig. 3 geodätisch so ausgerichtet (wie bezüglich des fahrzeugeigenen Koordinatensystems mit zueinander senkrechten Längs-, Quer- und Höhenachsen X, Y und Z gezeigt), dass sich Hardwarekomponenten des ersten Kanals 4 im Fahrzeug niedriger als Hardwarekomponenten des zweiten Kanals 5 befinden (wie zusätzlich durch Pfeile angedeutet). Zusätzlich sind in diesem Beispiel nur Hardwarekomponenten des zweiten Kanals 5 zum Schutz gegen Wasser oder andere Flüssigkeiten teillackiert. Sinnvollerweise wurden hierbei nur diejenigen Elemente des zweiten Kanals 5 mit schützendem Lack 6 beschichtet, die ohne diese Maßnahme auf Feuchtigkeit nach Schaltplan reagieren würden und insbesondere auch lackierfähig sind.

Das in Fig. 3 gezeigte Prinzip lässt sich analog auf gegebenenfalls vorhandene weitere Leiterplatten (nicht dargestellt) des Steuergeräts 1 erweitern/anwenden.

## Patentansprüche

1. Fahrzeug, insbesondere ein Kraftfahrzeug, umfassend:
- eine integrierte Fahrzeugeinrichtung; und
- ein Steuergerät (1), das zur elektrischen Ansteuerung der integrierten Fahrzeugeinrichtung, insbesondere einer Lenkung, einer Bremse oder eines elektrischen Antriebsstrangs, ausgebildet und eingerichtet ist.
wobei
- das Steuergerät (1) einen ersten Ansteuerungskanal (4) und einen redundanten zweiten Ansteuerungskanal (5), der zu einer unabhängigen Ansteuerung der Fahrzeugeinrichtung bei Ausfall des ersten Kanals (4) ausgebildet ist, umfasst;
- zumindest ein Teil von Hardware des ersten Kanals (4) derart flüssigkeitsempfindlich ausgebildet und angeordnet ist, dass ein Flüssigkeitseintritt ins Steuergerät (1) zu einer direkten oder automatisch herbeigeführten Abschaltung des ersten Kanals (4) führt; und
- Hardware des zweiten Kanals (5) derart flüssigkeitsgeschützt ausgebildet und/oder angeordnet ist, dass der zweite Kanal (5) bei Flüssigkeitseintritt ins Steuergerät (1) zumindest für eine vorbestimmte Zeitspanne weiter funktionsfähig bleibt, die zum Überführen des Fahrzeugs in einen vorbestimmten sicheren Zustand ausreicht,
wobei Hardware des zweiten Kanals (5) dadurch im Unterschied zur Hardware des ersten Kanals (4) flüssigkeitsgeschützt ausgebildet ist, dass Hardware des zweiten Kanals (5) bezüglich einer Höhenrichtung (Z) eines fahrzeugeigenen kartesischen Koordinatensystems höher als Hardware des ersten Kanals (4) angeordnet ist.

2. Fahrzeug nach Anspruch 1, wobei das Steuergerät (1) dazu eingerichtet ist, bei durch einen Flüssigkeitseintritt bedingter Abschaltung des ersten Kanals (4)
- die Fahrzeugeinrichtung über den zweiten Kanal (5) zum Überführen des Fahrzeugs in den vorbestimmten sicheren Zustand anzusteuern; und/oder
- ein Warnsignal für Fahrzeuginsassen und/oder Außenstehende zu erzeugen, das auf den Flüssigkeitseintritt ins Steuergerät (1) hinweist und zu einem sofortigen Abstellen des Fahrzeugs im vorbestimmten sicheren Zustand auffordert; und/oder
- mindestens eine vorbestimmte Weiterfahrt-Sperrmaßnahme im Fahrzeug zu aktivieren, sobald das Fahrzeug in den vorbestimmten sicheren Zustand überführt worden ist.

3. Fahrzeug nach einem der vorhergehenden Ansprüche, wobei
- Hardware des zweiten Kanals (5) dadurch im Unterschied zur Hardware des ersten Kanals (4) flüssigkeitsgeschützt ausgebildet ist, dass allein Hardware des zweiten Kanals (5) zumindest teilweise mit einer wasserdichten Abdeckung, insbesondere einem schützenden Lack (6), überzogen ist.

4. Fahrzeug nach einem der vorhergehenden Ansprüche,
- welches in zwei separate, räumlich und elektrisch voneinander getrennte Teil-Steuergeräte unterteilt ist,
- wobei der erste Kanal (4) in einem dieser Teil-Steuergeräte und der zweite Kanal (5) in dem anderen Teil-Steuergerät untergebracht ist.

5. Fahrzeug nach einem der vorhergehenden Ansprüche, wobei
- Hardware des ersten Kanals (4) für eine sichere Erkennung eines Flüssigkeitseintritts, der eine bloße Kondensation von Feuchtigkeit aus der Luft mengenmäßig um ein Vielfaches übersteigt, ausgebildet ist; und
- die direkte oder automatische Abschaltung des ersten Kanals (4) auf dieser Erkennung basiert.

6. Fahrzeug nach einem der vorhergehenden Ansprüche, wobei
- der erste Kanal (4) einen Sensor umfasst, der zum Erkennen eines Flüssigkeitseintritts im Bereich des ersten Kanals (4) und zum Ausgeben eines entsprechenden Signals an das Steuergerät (1) zum automatischen Abschalten des ersten Kanals (4) ausgebildet ist.

## Claims

1. Vehicle, in particular a motor vehicle, comprising:
- an integrated vehicle device; and
- a control unit (1) which is designed and configured to electrically control the integrated vehicle device, in particular a steering system, a brake or an electric drive train,
wherein
- the control unit (1) comprises a first control channel (4) and a redundant second control channel (5) which is designed to independently control the vehicle device in the event of a failure of the first channel (4);
- at least some of the hardware of the first channel (4) is designed and arranged to be sensitive to liquids such that liquid ingress into the control unit (1) leads to a directly or automatically induced shutdown of the first channel (4); and
- hardware of the second channel (5) is designed and/or arranged to be protected against liquids such that the second channel (5) remains functional in the event of liquid ingress into the control unit (1), for at least a predetermined period of time which is sufficient to transfer the vehicle into a predetermined safe state,
wherein, in contrast to the hardware of the first channel (4), hardware of the second channel (5) is designed to be protected against liquids, in that hardware of the second channel (5) is arranged higher than hardware of the first channel (4) with respect to a height direction (Z) of a vehicle's individual Cartesian coordinate system.

2. Vehicle according to claim 1, wherein the control unit (1) is configured, in the event of a shutdown of the first channel (4) induced by liquid ingress,
- to control the vehicle device via the second channel (5) in order to transfer the vehicle into the predetermined safe state;
and/or
- to generate a warning signal for vehicle occupants and/or external persons indicating liquid ingress into the control unit (1), and to prompt the immediate parking of the vehicle in the predetermined safe state; and/or
- to activate at least one predetermined measure to block further travel in the vehicle as soon as the vehicle has been transferred to the predetermined safe state.

3. Vehicle according to either of the preceding claims, wherein,
- in contrast to the hardware of the first channel (4), hardware of the second channel (5) is designed to be protected against liquids, in that only hardware of the second channel (5) is at least partially covered with a waterproof cover, in particular a protective coating (6).

4. Vehicle according to any of the preceding claims,
- which is divided into two separate sub-control units which are spatially and electrically separate from one another,
- wherein the first channel (4) is accommodated in one of these sub-control units and the second channel (5) is accommodated in the other sub-control unit.

5. Vehicle according to any of the preceding claims, wherein
- hardware of the first channel (4) is designed for reliable detection of liquid ingress, the quantity of which is multiple times greater than mere condensation of moisture from the air; and
- the direct or automatic shutdown of the first channel (4) is based on this detection.

6. Vehicle according to any of the preceding claims, wherein
- the first channel (4) comprises a sensor which is designed to detect liquid ingress into the region of the first channel (4) and to output a corresponding signal to the control unit (1) to automatically shut down the first channel (4).

## Revendications

1. Véhicule, en particulier un véhicule automobile, comprenant :
- un dispositif de véhicule intégré ; et
- un appareil de commande (1), qui est conçu et équipé pour la commande électrique du dispositif de véhicule intégré, en particulier d'une direction, d'un frein ou d'une chaîne cinématique électrique.
dans lequel
- l'appareil de commande (1) comprend un premier canal de commande (4) et un second canal de commande redondant (5) qui est conçu pour une commande indépendante du dispositif de véhicule en cas de défaillance du premier canal (4) ;
- au moins une partie du matériel du premier canal (4) est conçue et agencée de manière à être sensible aux liquides, de telle sorte qu'une entrée de liquide dans l'appareil de commande (1) entraîne une coupure directe ou provoquée automatiquement du premier canal (4) ; et
- le matériel du second canal (5) est conçu et/ou agencé de manière à être protégé contre les liquides de telle sorte que le second canal (5) reste encore fonctionnel en cas d'entrée de liquide dans l'appareil de commande (1) au moins pendant un laps de temps prédéterminé, qui suffit pour faire passer le véhicule dans un état de sécurité prédéterminé,
dans lequel le matériel du second canal (5) est conçu de manière à être protégé contre les liquides, à la différence du matériel du premier canal (4), en ce que le matériel du second canal (5) est agencé plus haut que le matériel du premier canal (4) par rapport à une direction de hauteur (Z) d'un système de coordonnées cartésiennes propre au véhicule.

2. Véhicule selon la revendication 1, dans lequel l'appareil de commande (1) est conçu pour, en cas de coupure du premier canal (4) en raison d'une entrée de liquide
- commander le dispositif de véhicule par l'intermédiaire du second canal (5) pour faire passer le véhicule dans l'état de sécurité prédéterminé ;
et/ou
- générer un signal d'avertissement pour les occupants de véhicule et/ou les personnes extérieures, qui indique l'entrée de liquide dans l'appareil de commande (1) et demande un arrêt immédiat du véhicule dans un état de sécurité prédéterminé ; et/ou
- activer au moins une mesure de blocage de poursuite de trajet prédéterminée dans le véhicule, dès que le véhicule est passé dans l'état de sécurité prédéterminé.

3. Véhicule selon l'une des revendications précédentes, dans lequel
- le matériel du second canal (5) est conçu de manière à être protégé contre les liquides, à la différence du matériel du premier canal (4), en ce que seul le matériel du second canal (5) est recouvert au moins partiellement d'un élément de recouvrement étanche à l'eau, en particulier d'un vernis protecteur (6).

4. Véhicule selon l'une des revendications précédentes,
- qui est divisé en deux sous-appareils de commande distincts, séparés physiquement et électriquement l'un de l'autre,
- dans lequel le premier canal (4) est monté dans l'un de ces sous-appareils de commande et le second canal (5) dans l'autre sous-appareil de commande.

5. Véhicule selon l'une des revendications précédentes, dans lequel
- le matériel du premier canal (4) est conçu pour une reconnaissance sûre d'une entrée de liquide, qui dépasse plusieurs fois en quantité une simple condensation d'humidité de l'air ; et
- la coupure directe ou automatique du premier canal (4) est basée sur cette reconnaissance.

6. Véhicule selon l'une des revendications précédentes, dans lequel
- le premier canal (4) comprend un capteur, qui est conçu pour reconnaître une entrée de liquide dans la zone du premier canal (4) et pour émettre un signal correspondant à l'appareil de commande (1) afin de couper automatiquement le premier canal (4).
